# EUROPEAN PATENT APPLICATION

(11) **EP 4 513 486 A1**
(43) Date of publication of application: **26.02.2025**
(21) Application number: 24192638.5
(22) Date of filing: 02.08.2024
(51) Int. Cl.: G11C 5/02, G11C 7/18, G11C 13/00

(54) **NON-VOLATILE MEMORY DEVICE, CORRESPONDING METHOD AND SYSTEM**

(30) Priority: 24.08.2023 IT 202300017553
(71) Applicant: STMicroelectronics International N.V., 1228 Plan-les-Ouates, Geneva (CH)
(72) Inventor: PERRONI, Maurizio Francesco, I-98054 Furnari (Messina) (IT); DISEGNI, Fabio Enrico Carlo, I-26016 Spino d'Adda (Cremona) (IT); TORTI, Cesare, I-27100 Pavia (IT); MANFRE', Davide, I-26025 Pandino (Cremona) (IT); CARUSO, Massimo, I-98122 Messina (IT)
(74) Representative: Buzzi, Notaro & Antonielli d'Oulx S.p.A.

(57) **Abstract**

A device (20), comprising a memory array (28) comprising memory cells arranged in a set of memory portions (280, 282) and addressable via a pair of row and column values, wherein each memory portion in the set of memory portions (280, 282) comprises at least one sector of memory cells (S) arranged in rows and columns. The device (20) comprises: a set of sense amplifier circuits (240) coupled to and interposed adjacent memory portions in the set of memory portions (280, 282) of the memory array (28); a control circuit (CL) configured to provide at least one address signal (AS) indicative of a pair of row and column values to localize at least one addressed memory cell in the memory array (28), the control circuit (CL) being further configured to issue read or write access requests towards the at least one addressed memory cell in the memory array (28); a first set of access devices (YO) configured to be made conductive to couple (LBL) an addressed memory cell in a respective memory portion of the set of memory portions (280, 282) of the memory array (28) to the respective sense amplifier circuit in the set of sense amplifier circuits (240) in response to a read access request issued by the control circuit (CL); a second set of access devices (11) configured to be made conductive to couple an addressed memory cell in a respective memory portion of the set of memory portions (280, 282) of the memory array (28) to the programming bitline (WL) in response to a write access request issued by the control circuit (CL).

## Description

### Technical field

The description relates to non-volatile memory (briefly, NVM) systems and methods.

One or more embodiments may be applied to a variety of NVM technologies, such as phase-change memories (briefly,PCM), magnetoresistive random access memories (briefly, MRAM), resistive random access memories (briefly, RRAM), for instance.

### Background

The term "non-volatile memory" currently refers to semiconductor technologies that can retain data or program code stored in a computing device also in the absence of a continuous power supply.

There is a wide variety of NVM systems. For instance, in a subset of NVMs, the state of a memory cell can be changed via a variation of an electrical current flowing through the cell. As an example, US 10 515 697 B1 discloses a method to control operations performed on resistive memory cells. US 2006/181932 A1 discloses a method for pulse width control in a phase-change memory device.

WO 2005/117021 A1 discloses an example of non-volatile memory device. US 2015/243355 A1 discloses a method for reducing peak current in a variable resistance memory device.

Conventional NVM systems comprise:
a program driver configured to write (e.g., a single bit) to memory, and
a sense amplifier configured to read (e.g., deciding the logic level to assign to the sensed current level).

Conventionally, sense amplifier and program driver are located on the top of an array of bit cells of the NVM. A common main bitline is used to perform both read and write operations from/to memory.

For instance, if the main bitline has a length about 800 micron (1 micron = 10⁻⁶ m = 1 micrometer), an access time to the memory cells may introduce a lag about 1.5ns (1 ns = 10⁻⁹ s = 1 nanosecond) on operations, which may be considered inconvenient depending on the application.

### Object and summary

An object of one or more embodiments is to contribute in overcoming the aforementioned drawbacks.

According to one or more embodiments, that object can be achieved via a (e.g., non-volatile memory) device having the features set forth in the claims that follow.

One or more embodiments may relate to a corresponding method.

One or more embodiments may relate to a corresponding (e.g., FLASH memory) system.

The claims are an integral part of the technical teaching provided herein with reference to the embodiments.

One or more embodiments may facilitate providing an adequate access time for read/write (briefly, R/W) operations performed on a NVM system.

One or more embodiments may facilitate a reduced silicon footprint.

### Brief description of the several views of the drawings

One or more embodiments will now be described, by way of non-limiting example only, with reference to the annexed Figures, wherein:
- Figure 1 is a diagram exemplary of a non-volatile memory device,
- Figure 2 is a diagram exemplary of a device as per the present disclosure,
- Figure 3 is a diagram exemplary of a read operation in a method as per the present disclosure,
- Figure 4 is a diagram exemplary of a write operation in a method as per the present disclosure,
- Figure 5 is a diagram exemplary of a non-volatile memory device as per the present disclosure,
- Figure 6 is a diagram exemplary of a system equipped with a non-volatile memory device as per the present disclosure.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The references used herein are provided merely for convenience and hence do not define the extent of protection or the scope of the embodiments.

For the sake of simplicity, in the following detailed description a same reference symbol may be used to designate both a node/line in a circuit and a signal which may occur at that node or line.

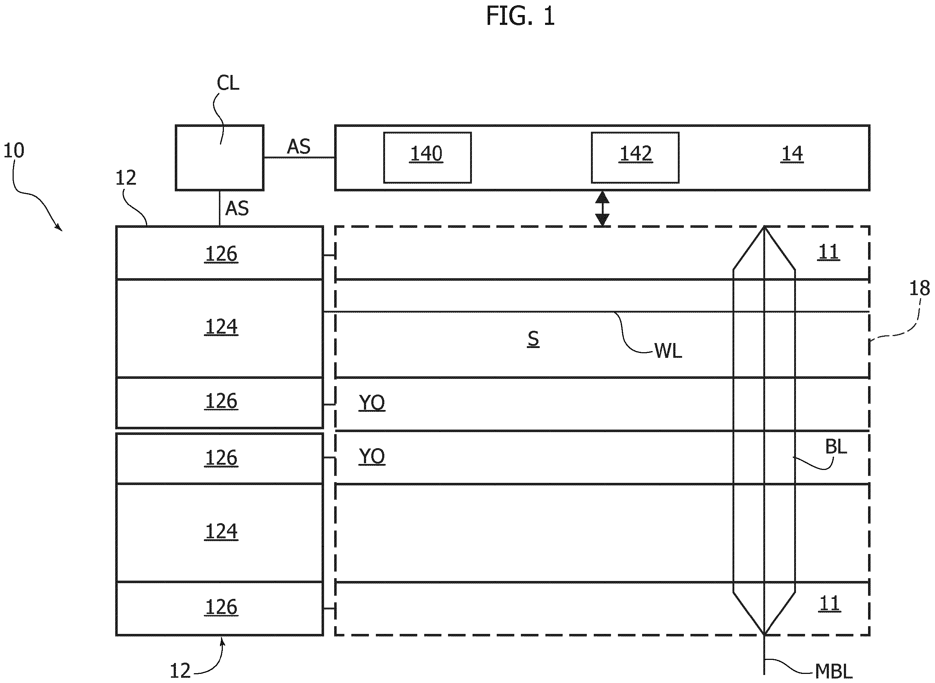

Figure 1 exemplifies a conventional non-volatile memory (briefly, NVM) device 10 comprising:
an array 18 of memory cells, per se known; the memory cells of the array 18 are arranged in rows, or wordlines, and columns, or bitlines BL; purely by way of non-limiting example, illustrated in Figure 1 is one wordline, designated by WL, and two bitlines, designated by BL, coupled to a main bitline, designated by MBL;
a set of column decoders 11 and a set of row decoder 12, which comprise access devices configured to select memory cells of the array on the basis of address signals received at input (designated as a whole by AS),
a R/W interface 14 comprising a sense amplifier 140 and a program driver 142 for reading and writing data to memory.

For instance, memory cells in the array 18 comprise phase-change memory (briefly, PCM) cells comprising materials that may switch between a disorderly/amorphous phase and an orderly (crystalline or polycrystalline) phase, where different phases are characterized by different values of resistivity and are consequently associated to different values of a datum stored in the memory cell.

As exemplified in Figure 1, the address signals AS can be generated by a control logic CL configured to drive the column decoder and the row decoder of the array 18 so as to enable reading and writing (also known as programming) of the memory cells addressed by the address signals AS.

For instance, the control logic CL supplies to the R/W interface 14 also control signals in order to govern the reading/writing operations.

As appreciable to those of skill in the art, the set of column and row decoders 11, 12 are configured to bias, and hence select, the wordlines WL and bitlines BL each time selected so as to select the memory cells of the array 18 coupled thereto; in this way, reading and writing of the memory cells of the array 18 is enabled.

Specifically, the row decoders 12 are designed to select, on the basis of the address signals AS, a corresponding wordline WL, while the other wordlines are deselected. To this end, the row decoder 12 comprises a decoding stage 124 and a plurality of driving circuits 126.

As exemplified in Figure 1, the decoding stage 124 receives the address signals AS from the control logic CL and operates the driving circuits 126 according to the address signals AS. Each driving circuit in the plurality of driving circuits 126 has an input which is coupled to the decoding stage 124.

As regards the set of column decoder 11, these comprise access elements/devices (e.g., transistors) configured to select one or more bitlines BL based on the address signals AS.

As exemplified in Figure 1, the access devices in column decoders 11 co-operates with those of row decoders 12 in such a way that, during the steps of reading or writing of any memory cell selected within the array 18, a reading current or a writing current, respectively, flows through a storage element of the memory cell of the array 18.

For instance, the access devices in the set of column decoders 11 are configured for implementing two distinct paths towards the bitlines BL of the memory array 18 each time selected:
- a reading path which electrically connects each bitline BL selected to a sense amplifier 140 during the reading step, and
- a writing path which electrically connects each bitline BL selected to a program driver circuit (not visible in Figure 1) during the programming step.

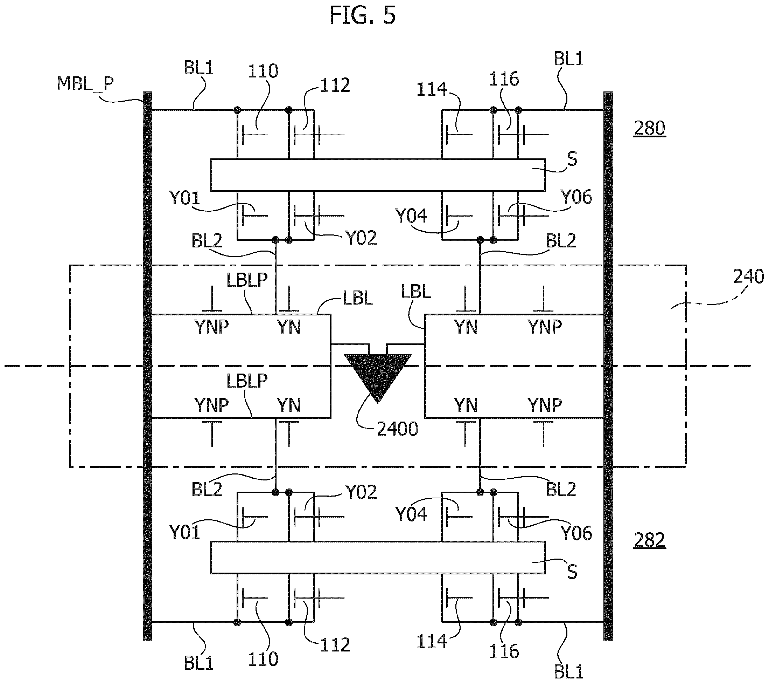

As exemplified herein, the column decoders 11 comprise, for each reading and writing path, appropriate access or selection elements/devices (e.g., transistors, see for instance Figure 5) coupled therebetween so as to implement a hierarchical decoding of the address signals AS in order to select the memory cells of the memory array 18.

As illustrated schematically in Figure 1, the memory array 18 can be organized in a plurality of sectors S, each of which comprises a plurality of memory cells.

For instance, each sector S includes a plurality of respective wordlines WL and a plurality of respective local bitlines, which are designated once again by BL and are distinct from those of the other sectors.

As exemplified in Figure 1, in each sector S the local bitlines BL are connected to the memory cells of one and the same sector S. In the considered example in Figure 1, for each set formed by an integer number k (for example, thirty-two) of local bitlines BL, a corresponding main bitline MBL is provided.

For instance, the main bitlines MBL enable, when selected at a higher hierarchical level, subsequent selection, at a lower hierarchical level, of one or more of the respective local bitlines BL and of the corresponding memory cells. In addition, different sectors S are traversed by different wordlines WL.

As exemplified in Figure 1, the main bitlines MBL traverse a certain number of sectors S and can be selected in groups at a hierarchical decoding level even higher than the one associated to selection of the main bitlines MBL.

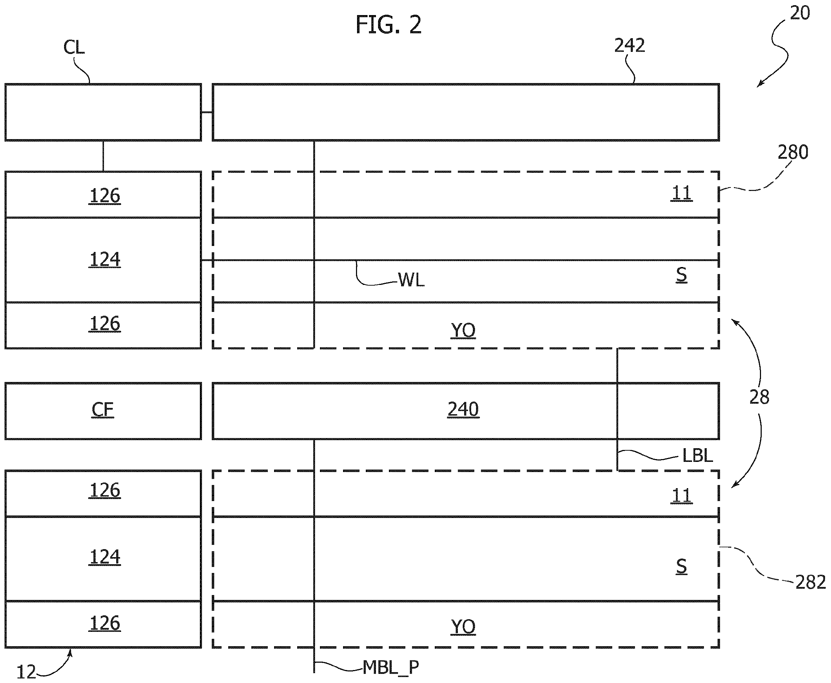

For instance, at least one respective first-level decoding circuit (designated by 11 in Figure 1 and also known as "local column decoder") enables connection of the local bitlines BL to the respective main bitlines MBL both during the write operations and during the read operations; for each group of sectors S (comprising, in the example of Figure 2, two sectors), a respective second-level decoding circuit enables selection of the main bitlines MBL both during the write operations and during the read operations.

For instance, the control logic CL sends to the decoding circuit 11 a subset of the address signals AS including column-decoding signals sYN<i> on the basis of which the decoding circuit activates an electrical path between a main bitline (e.g., MBL<i>) selected and a sense amplifier 140, via activation of a respective main selection switch (not visible).

Furthermore, given a sector S, the corresponding first-level decoding circuit 11 is able to address each memory cell coupled to a local bitline BL of the sector S thanks to the presence of local selection switches, which are driven by respective local column-decoding control signals YO (for respective access devices), which are generated by the control logic CL and also form part of the aforementioned address signals AS.

Inventors have observed that distributing the components of the R/W interface 14 may speed up access to various memory sections.

As exemplified in Figure 2, a memory device 20 as per the present disclosure comprises:
a memory array 28 organized in a plurality of memory portions (also denoted as sub-arrays) 280, 282 each comprising at least one sector S of the memory array 28, where each sector S comprises a respective plurality of memory cells of the array 28 and a plurality of respective wordlines WL; moreover, each sector S is coupled to a main bitline MBL_P to receive therefrom data to write to the respective memory cells of the array 28;
a program driver circuit block 242 coupled to the control logic CL to receive the address signals AS therefrom and coupled to the memory portions 280, 282 via a main programming bitline MBL_P, and
a set of sense amplifier circuit blocks 240 located intermediate different memory portions 280, 282 of the memory array 28.

For instance, the sense amplifier circuit blocks 240 are coupled via local bitlines LBL to the memory cells of the sections S of a respective memory portion (e.g., 280) adjacent each sense amplifier circuit block in the set of sense amplifier circuit blocks 240.

For the sake of simplicity, one or more embodiments are discussed in the following with respect to a case in which the memory array 28 comprises a first memory portion 280 and a second memory portion 282 and a sense amplifier circuit block 240 intermediate the two portions 280, 282, being otherwise understood that such a case is purely exemplary and in no way limiting. One or more embodiments may comprise notionally any number of memory portions and a corresponding number of sense amplifier circuit blocks arranged interleaved with respect to the various memory portions.

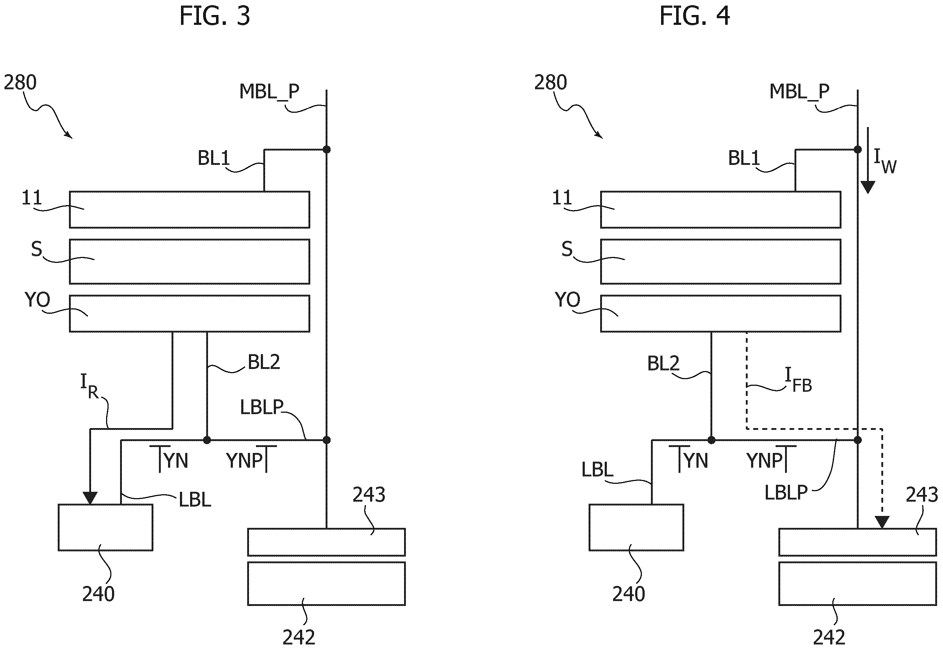

Figures 3 and 4 are diagrams exemplary of operations of reading data from (Figure 3) and writing data to (Figure 4) memory cells in a sector S of a memory portion 280 of the memory array 28 using the solution as per the present disclosure.

As appreciable to those of skill in the art, in the case of a phase-change memory (briefly, PCM), access (or selection) devices such as bipolar or MOS transistors can be coupled to the heaters and selectively enable passage of a programming electric current (also known as writing electric current) through them; this electric current, by the Joule effect, generates the heat required for phase change, and in particular for switching from a high-resistivity state (known as RESET state) to a low-resistivity state (the so-called SET state), or vice versa, in a manner per se known. During a reading operation, the state of the phase-changing material may be detected by applying a voltage that is sufficiently low as not to cause a sensible heating thereof, and then reading the value of the current that flows in the memory cell through a sense amplifier circuit block 240. Since the current is proportional to the conductivity of the phase-change material, it is possible to determine in which state the material is and consequently determine the datum stored in the memory cell of the array 28.

As exemplified in Figure 3, an operation of reading data from at least one memory cell in a memory array portion 280 comprises:
receiving from the control logic an address signal AS of the memory cell storing the data to read among the memory cells in the memory array 28;
making selectively non-conductive 11 a first bitline portion BL1 coupling the main bitline MBL_P to the memory array portion 280;
enabling, via an enable signal YN, coupling a local bitline LBL to a second bitline portion BL2,
making selectively conductive YO the second bitline portion BL2 and the local bitline portion LBL, coupling the array sector S of the memory portion 280 to the adjacent sense amplifier 240 as a result;
sensing, via the sense amplifier 240, the current I_{R} flowing through the second bitline portion BL2 and the local bitline LBL as a result of accessing the memory cell having an address corresponding to the address signal AS.

As exemplified in Figure 4, an operation of writing data to at least one memory cell in a sector S in a memory portion 180 of the memory array 18 comprises:
receiving from the control logic an address signal AS of a memory cell storing the data to be read among memory cells in the memory array 18;
making selectively conductive 11 the first bitline portion BL1 coupling the main bitline MBL_P to the memory array portion 280, providing the data to write I_{W} via the main programming bitline MBL_P;
coupling, via an enable signal YNP, for instance driven by a decoder 243, the program driver 242 to the second bitline portion BL2 of the memory array portion 280 via a further local bitline portion LBLP,
making selectively conductive YO the second bitline portion BL2, coupling the sector S of the memory array to program driver 242 via the further local bitline portion LBLP;
sensing, via the program driver 242, the current I_{FB} flowing through the second bitline portion BL2 and the further local bitline portion LBLP to check that data has been correctly written and to end the write operation.

Thanks to the device 20 exemplified in Figure 2, the current flowing in the local bitline during read operations can be much lower (e.g., about 20 µA, with 1 µA=10⁻⁶ A=1 microAmpere) than the current flowing on the main bitline MBL_P during write operations (e.g., about 800 µA). As a result, the latency of performing read operations can be reduced significantly, in particular with respect to the latency to perform write operations.

As exemplified in Figure 5, each memory portion 280, 282 comprises a memory section S surrounded by:
- a first set of access devices 110, 112, 114, 116 (e.g., MOSFET or BJT transistors) configured to selectively make conductive the first portion BL1 of the bitline coupling the main bitline MBL_P with the array section S, and
- a second set of access devices YO1, YO2, YO4, YO6 (e.g., MOSFET or BJT transistors) configured to selectively make conductive the second portion BL2 of the bitline coupling the array section S with the sense amplifier circuit block 240.

As exemplified in Figure 5, the sense amplifier circuit block 240 comprises:
a sense amplifier 2400 configured to sense an electrical current I_{R} flowing at its input and to produce as an output a logic level based on the sensed electrical current I_{R};
at least one first access device YN configured to provide a current flow path therethrough (corresponding to the local bitline LBL) to selectively couple the second portion of the bitline BL2 and the sense amplifier 2400 to provide the read current I_{R} thereto, and
at least one second access device YNP configured to provide a current flow path therethrough (corresponding to the further local bitline LBLP) to selectively couple the second portion of the bitline BL2 with the main bitline MBL_P to provide the feedback current I_{FB} to the program driver circuit block (not visible in Figure 5).

As exemplified herein, a device 20 comprises:
a memory array 28 comprising memory cells arranged in a set of memory portions 280, 282 and addressable via a pair of row and column values, wherein each memory portion in the set of memory portions (280, 282) comprises at least one sector of memory cells (S) arranged in rows and columns.

For instance, the device 20 further comprises:
a set of sense amplifier circuits 240; 2400 comprising sense amplifier circuits coupled to and interposed adjacent memory portions in the set of memory portions 280, 282 of the memory array;
a control circuit CL coupled to the memory array and configured to provide at least one address signal AS indicative of a pair of row and column values to localize at least one addressed memory cell in the memory array, the control circuit being further configured to issue read or write access requests towards the at least one addressed memory cell in the memory array;
a first set of access devices YO, YN coupled to the control circuit, to the memory cells in the memory array and to the set of sense amplifiers 240, the access devices in the first set of access devices being configured to be made conductive to couple BL2, LBL an addressed memory cell in a respective memory portion of the set of memory portions of the memory array to the respective sense amplifier circuit in the set of sense amplifier circuits in response to a read access request issued by the control circuit;
a second set of access devices 11, YNP coupled to the control circuit, to the memory cells in the memory array and to a programming bitline WL, MBL_P, the access devices in the second set of access devices 11, YNP being configured to be made conductive to couple BL1, BL2, LBLP an addressed memory cell in a respective memory portion of the set of memory portions of the memory array to the programming bitline in response to a write access request issued by the control circuit.

As exemplified herein, the first set of access devices comprises:
a first subset of access devices YO; YO1, YO2, YO4, YO6 coupled to the memory portion in the set of memory portions of the addressed memory cell and to a local bitline portion BL2, and
a second subset of access devices YN coupled to the local bitline portion BL2 and to a sense amplifier circuit 2400 in the set of sense amplifier circuits.

For instance, in response to issuing a read signal by the control logic:
access devices in the first subset of access devices are made conductive, coupling the addressed memory cell to the local bitline portion as a result, and
access devices in the second subset of access devices are made conductive to provide a current flow path LBL from the local bitline portion to the sense amplifier, with an electric current I_{R} flowing from the addressed memory cell to the sense amplifier as a result.

As exemplified herein, the second set of access devices comprises:
a third subset of access devices 11; 110, 112, 114, 116 coupled to the memory portion in the set of memory portions 280, 282 of the addressed memory cell and to the main programming bitline WL, MBL_P, and
a fourth subset of access devices YNP coupled to the main programming bitline WL, MBL_P.

For instance, in response to issuing a write signal by the control logic (CL):
access devices in the third subset of access devices are made conductive, coupling the addressed memory cell to the main programming (bit)line to receive a programming electric current (I_{W}) as a result, and
access devices in the fourth subset of access devices are made conductive to provide a current flow path (LBLP), with a feedback electric current I_{FB} flowing from the addressed memory cell to the main programming bitline WL, MBL_P as a result.

As exemplified herein, the devices comprises a program driver circuit 242 coupled to:
the control logic to receive address signals therefrom,
the programming bitline, and
access devices in the second set of access devices.

For instance, the program driver circuit is configured to receive the feedback current from the addressed memory cell in the set of memory portions of the memory array in response to access devices in the fourth subset of access devices of the second set of access devices being made conductive.

As exemplified herein, memory cells in the memory array are phase-change memories, PCM.

As exemplified herein, a method comprises providing a memory array 28 comprising memory cells arranged in a set of memory portions 280, 282 and addressable via a pair of row and column values. For instance, each memory portion in the set of memory portions comprises at least one sector of memory cells S arranged in rows and columns.

As exemplified herein, the method further comprises:
coupling and interposing sense amplifier circuits in a set of sense amplifier circuits 240; 2400 to adjacent memory portions in the set of memory portions of the memory array;
coupling a control circuit CL to the memory array, the control circuit configured to provide at least one address signal AS indicative of a pair of row and column values to localize at least one addressed memory cell in the memory array, the control circuit being further configured to issue read or write access requests towards the at least one addressed memory cell in the memory array;
coupling a first set of access devices YO, YN to the control circuit, to the memory cells in the memory array and to the set of sense amplifiers, the access devices in the first set of access devices being configured to be made conductive to couple BL2, LBL an addressed memory cell in a respective memory portion of the set of memory portions of the memory array to the respective sense amplifier circuit in the set of sense amplifier circuits in response to a read access request issued by the control circuit;
coupling a second set of access devices to the control circuit, to the memory cells in the memory array and to a programming bitline, the access devices in the second set of access devices being configured to be made conductive to couple an addressed memory cell in a respective memory portion of the set of memory portions of the memory array to the programming bitline in response to a write access request issued by the control circuit.

As exemplified herein, coupling the first set of access devices comprises:
coupling a first subset of access devices to the memory portion in the set of memory portions of the addressed memory cell and to a local bitline portion, and
coupling a second subset of access devices to the local bitline portion and to a sense amplifier circuit in the set of sense amplifier circuits.

For instance, in response to issuing a read signal by the control logic:
access devices in the first subset of access devices are made conductive, coupling the addressed memory cell to the local bitline portion as a result, and
access devices in the second subset of access devices are made conductive to provide a current flow path from the local bitline portion to the sense amplifier, with an electric current I_{R} flowing from the addressed memory cell to the sense amplifier as a result.

As exemplified herein, coupling the second set of access devices comprises:
coupling a third subset of access devices to the memory portion in the set of memory portions of the addressed memory cell and to the main programming bitline, and
coupling a fourth subset of access devices to the main programming bitline.

For instance, in response to issuing a write signal by the control logic CL:
access devices in the third subset of access devices are made conductive, coupling the addressed memory cell to the main programming (bit)line to receive a programming electric current as a result, and
access devices in the fourth subset of access devices are made conductive to provide a current flow path, with a feedback electric current flowing from the addressed memory cell to the main programming bitline as a result.

As exemplified herein, the method comprises coupling a program driver circuit to:
the control logic to receive address signals therefrom,
the programming bitline, and
access devices in the second set of access devices,
wherein the method comprises receiving, via the program driver circuit, the feedback current from the addressed memory cell in the set of memory portions of the memory array in response to access devices in the fourth subset of access devices of the second set of access devices being made conductive.

A system 500 equipped with a device 20 as per the present disclosure may further comprise a digital-to-analog converter circuit DAC configured to produce an electric current I_{W} to provide to the main programming (bit)line WL, MBL_P, preferably via a program driver circuit (242) coupled thereto.

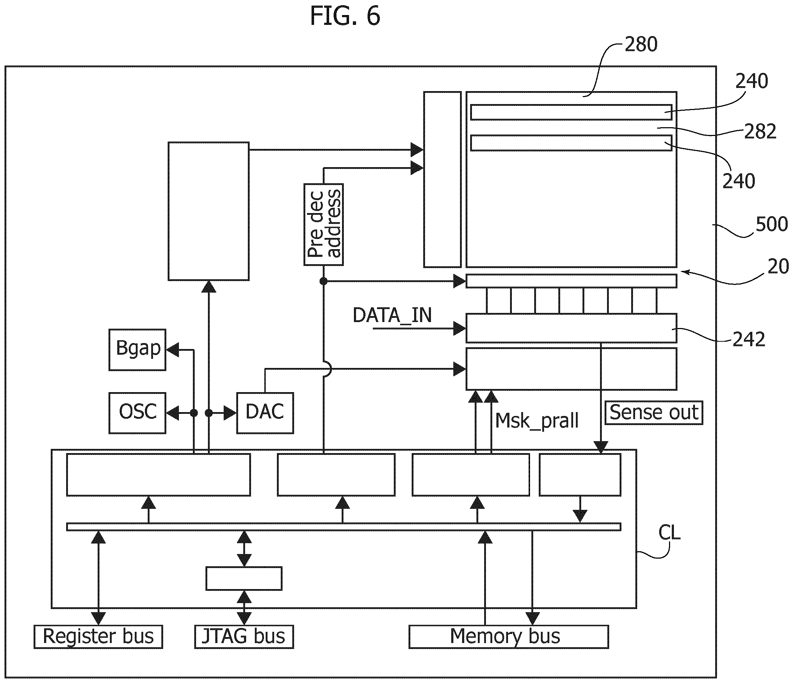

As exemplified in Figure 6, a system as per the present disclosure comprises:
a memory device 20 as exemplified in Figure 2;
a control logic CL comprising a plurality of interfaces to operate on the memory device 20;
a plurality of serve circuits, such as bandgap circuits BGAP, local oscillator circuits OSC, digital-to-analog converter circuits DACT, buses and so on configured to be coupled to various parts of the device to drive operation thereof, as appreciable to those of skill in the art.

As exemplified in Figure 6:
- the bandgap circuit BGAP provides a reference voltage of the analogic circuitry within the memory 20;
- the oscillator circuit block OSC is configured to generate a clock signal to run the read/write instruction operations on the control logic CL;
- a digital to analog converter circuit block DAC is configured to generate the current intensity values of the write currents I_{W} during write operations;

the decoder circuit block "Pre dec Address" is configured to apply decoding processing to address signals AS in order to drive the decoders 11, 14; and
a mask circuit block msk_prall configured to store information related to bits of the array to program during a write operation.

It will be otherwise understood that the various individual implementing options exemplified throughout the figures accompanying this description are not necessarily intended to be adopted in the same combinations exemplified in the figures. One or more embodiments may thus adopt these (otherwise non-mandatory) options individually and/or in different combinations with respect to the combination exemplified in the accompanying figures.

Without prejudice to the underlying principles, the details and embodiments may vary, even significantly, with respect to what has been described by way of example only, without departing from the extent of protection. The extent of protection is defined by the annexed claims.

## Claims

1. A device (20), comprising:
a memory array (28) comprising memory cells arranged in a set of memory portions (280, 282) and addressable via a pair of row and column values,
wherein each memory portion in the set of memory portions (280, 282) comprises at least one sector of memory cells (S) arranged in rows and columns,
wherein the device (20) comprises:
a set of sense amplifier circuits (240; 2400) comprising sense amplifier circuits coupled to and interposed adjacent memory portions in the set of memory portions (280, 282) of the memory array (28);
a control circuit (CL) coupled to the memory array (28) and configured to provide at least one address signal (AS) indicative of a pair of row and column values to localize at least one addressed memory cell in the memory array (28), the control circuit (CL) being further configured to issue read or write access requests towards the at least one addressed memory cell in the memory array (28);
a first set of access devices (YO, YN) coupled to the control circuit (CL), to the memory cells in the memory array (28) and to the set of sense amplifiers (240), the access devices in the first set of access devices (YO, YN) being configured to be made conductive to couple (BL2, LBL) an addressed memory cell in a respective memory portion of the set of memory portions (280, 282) of the memory array (28) to the respective sense amplifier circuit in the set of sense amplifier circuits (240) in response to a read access request issued by the control circuit (CL);
a second set of access devices (11, YNP) coupled to the control circuit (CL), to the memory cells in the memory array (28) and to a programming bitline (WL, MBL_P), the access devices in the second set of access devices (11, YNP) being configured to be made conductive to couple (BL1, BL2, LBLP) an addressed memory cell in a respective memory portion of the set of memory portions (280, 282) of the memory array (28) to the programming bitline (WL, MBL_P) in response to a write access request issued by the control circuit (CL).

2. The device of claim 1, wherein the first set of access devices (YO, YN) comprises:
a first subset of access devices (YO; YO1, YO2, YO4, YOG) coupled to the memory portion in the set of memory portions (280, 282) of the addressed memory cell and to a local bitline portion (BL2), and
a second subset of access devices (YN) coupled to the local bitline portion (BL2) and to a sense amplifier circuit (2400) in the set of sense amplifier circuits (240),
wherein, in response to issuing a read signal by the control logic (CL):
access devices in the first subset of access devices (YO; YO1, YO2, YO4, YO6) are made conductive, coupling the addressed memory cell to the local bitline portion (BL2) as a result, and
access devices in the second subset of access devices (YN) are made conductive to provide a current flow path (LBL) from the local bitline portion (BL2) to the sense amplifier (2400), with an electric current (IR) flowing from the addressed memory cell to the sense amplifier (2400) as a result.

3. The device (20) of claim 1 or claim 2, wherein the second set of access devices (11, YNP) comprises:
a third subset of access devices (11; 110, 112, 114, 116) coupled to the memory portion in the set of memory portions (280, 282) of the addressed memory cell and to the main programming bitline (WL, MBL_P), and
a fourth subset of access devices (YNP) coupled to the main programming bitline (WL, MBL_P),
wherein, in response to issuing a write signal by the control logic (CL):
access devices in the third subset of access devices (11; 110, 112, 114, 116) are made conductive, coupling the addressed memory cell to the main programming line to receive a programming electric current (I_{W}) as a result, and
access devices in the fourth subset of access devices (YNP) are made conductive to provide a current flow path (LBLP), with a feedback electric current (I_{FB}) flowing from the addressed memory cell to the main programming bitline (WL, MBL_P) as a result.

4. The device (20) of claim 3, comprising a program driver circuit (242) coupled to:
the control logic (CL) to receive address signals (AS) therefrom,
the programming bitline (WL, MBL_P), and
access devices in the second set of access devices (11, YNP),
wherein the program driver circuit (242) is configured to receive the feedback current (I_{FB}) from the addressed memory cell in the set of memory portions (280, 282) of the memory array (28) in response to access devices in the fourth subset of access devices (YNP) of the second set of access devices (11, YNP) being made conductive.

5. The device (20) of any one of the previous claims, wherein memory cells in the memory array are phase-change memories, PCM.

6. A method, comprising:
providing a memory array (28) comprising memory cells arranged in a set of memory portions (280, 282) and addressable via a pair of row and column values,
wherein each memory portion in the set of memory portions (280, 282) comprises at least one sector of memory cells (S) arranged in rows and columns,
wherein the method comprises:
coupling and interposing sense amplifier circuits in a set of sense amplifier circuits (240; 2400) to adjacent memory portions in the set of memory portions (280, 282) of the memory array (28);
coupling a control circuit (CL) to the memory array (28), the control circuit (CL) configured to provide at least one address signal (AS) indicative of a pair of row and column values to localize at least one addressed memory cell in the memory array (28), the control circuit (CL) being further configured to issue read or write access requests towards the at least one addressed memory cell in the memory array (28);
coupling a first set of access devices (YO, YN) to the control circuit (CL), to the memory cells in the memory array (28) and to the set of sense amplifiers (240), the access devices in the first set of access devices (YO, YN) being configured to be made conductive to couple (BL2, LBL) an addressed memory cell in a respective memory portion of the set of memory portions (280, 282) of the memory array (28) to the respective sense amplifier circuit in the set of sense amplifier circuits (240) in response to a read access request issued by the control circuit (CL);
coupling a second set of access devices (11, YNP) to the control circuit (CL), to the memory cells in the memory array (28) and to a programming bitline (WL, MBL_P), the access devices in the second set of access devices (11, YNP) being configured to be made conductive to couple (BL1, BL2, LBLP) an addressed memory cell in a respective memory portion of the set of memory portions (280, 282) of the memory array (28) to the programming bitline (WL, MBL_P) in response to a write access request issued by the control circuit (CL).

7. The method of claim 6, wherein coupling the first set of access devices (YO, YN) comprises:
Coupling a first subset of access devices (YO; YO1, YO2, YO4, YO6) to the memory portion in the set of memory portions (280, 282) of the addressed memory cell and to a local bitline portion (BL2), and
Coupling a second subset of access devices (YN) to the local bitline portion (BL2) and to a sense amplifier circuit (2400) in the set of sense amplifier circuits (240),
wherein, in response to issuing a read signal by the control logic (CL):
access devices in the first subset of access devices (YO; YO1, YO2, YO4, YO6) are made conductive, coupling the addressed memory cell to the local bitline portion (BL2) as a result, and
access devices in the second subset of access devices (YN) are made conductive to provide a current flow path (LBL) from the local bitline portion (BL2) to the sense amplifier (2400), with an electric current (I_{R}) flowing from the addressed memory cell to the sense amplifier (2400) as a result.

8. The method of claim 6 or claim 7, wherein coupling the second set of access devices (11, YNP) comprises:
coupling a third subset of access devices (11; 110, 112, 114, 116) to the memory portion in the set of memory portions (280, 282) of the addressed memory cell and to the main programming bitline (WL, MBL_P), and
coupling a fourth subset of access devices (YNP) to the main programming bitline (WL, MBL_P),
wherein, in response to issuing a write signal by the control logic (CL):
access devices in the third subset of access devices (11; 110, 112, 114, 116) are made conductive, coupling the addressed memory cell to the main programming line (WL, MBL_P) to receive a programming electric current (I_{W}) as a result, and
access devices in the fourth subset of access devices (YNP) are made conductive to provide a current flow path (LBLP), with a feedback electric current (I_{FB}) flowing from the addressed memory cell to the main programming bitline (WL, MBL_P) as a result.

9. The method of claim 8, comprising coupling a program driver circuit (242) to:
the control logic (CL) to receive address signals (AS) therefrom,
the programming bitline (WL, MBL_P), and
access devices in the second set of access devices (11, YNP),
wherein the method comprises receiving, via the program driver circuit (242), the feedback current (I_{FB}) from the addressed memory cell in the set of memory portions (280, 282) of the memory array (28) in response to access devices in the fourth subset of access devices (YNP) of the second set of access devices (11, YNP) being made conductive.

10. A system (500) equipped with the device (20) according to any one of the previous claims, the system (500) comprising:
a device (20) according to any one of claims 1 to 5, and
a digital-to-analog converter circuit (DAC) configured to produce an electric current (I_{W}) to provide to the main programming bitline (WL, MBL_P), preferably via a program driver circuit (242) coupled thereto.
